**Europäisches Patentamt**

**European Patent Office**

**Office européen des brevets**

(19)

(11) Numéro de publication : **0 441 716 B1**

# (12) FASCICULE DE BREVET EUROPEEN

(45) Date de publication du fascicule du brevet :
**29.03.95 Bulletin 95/13**

(51) Int. Cl.$^6$ : **H03H 11/24**

(21) Numéro de dépôt : **91420021.7**

(22) Date de dépôt : **25.01.91**

(54) **Circuit à résistance variable commandée en tension.**

(30) Priorité : **31.01.90 FR 9001379**

(43) Date de publication de la demande :
**14.08.91 Bulletin 91/33**

(45) Mention de la délivrance du brevet :
**29.03.95 Bulletin 95/13**

(84) Etats contractants désignés :
**CH DE ES FR GB IT LI**

(56) Documents cités :
**EP-A- 0 210 067**
**US-A- 3 986 060**

(56) Documents cités :
**IEEE TRANSACTIONS ON CIRCUITS AND
SYSTEMS. vol. cas30, no. 10, octobre 1983,
NEW YORK US pages 770 - 772; K. Nay et al.:
"A Voltage-Controlled Resistance with Wide
Dynamic Range and Low Distortion"**

(73) Titulaire : **SGS-THOMSON
MICROELECTRONICS S.A.
7, Avenue Galliéni
F-94250 Gentilly (FR)**

(72) Inventeur : **Bret, Gérard
9, Place de Valmy
F-38130 Echirolles (FR)**

(74) Mandataire : **de Beaumont, Michel
1bis, rue Champollion
F-38000 Grenoble (FR)**

# Description

La présente invention concerne les circuits à résistance variable dont la valeur de la résistance est commandée par un signal électrique, en particulier par une tension.

Un circuit à résistance variable est constitué, de façon générale, d'un dipôle dont la résistance ou l'impédance prend une valeur donnée en fonction d'une grandeur électrique, par exemple une tension, appliquée à des bornes de commande du circuit.

Les circuits à résistance variable sont utilisés fréquemment dans un grand nombre de dispositifs électroniques. Ils sont utilisés, par exemple, pour commander un courant ou une tension, pour régler un gain ou une atténuation, ou pour régler des paramètres de filtres.

On peut réaliser un circuit à résistance variable en utilisant un transistor de type MOS. En effet, dans un transistor MOS, la résistance s'établissant entre les deux électrodes principales varie en fonction de la tension appliquée à l'électrode de commande. En d'autres termes, la résistance entre le drain et la source d'un transistor MOS varie en fonction de la tension appliquée entre la grille et la source. Un simple transistor MOS peut donc constituer, de manière satisfaisante, une résistance variable commandée en tension. Un tel montage à résistance variable ne fonctionne correctement que si le transistor MOS reste à tout instant dans la zone linéaire de la caractéristique du courant drain-source en fonction de la tension drain-source. Si la tension drain-source dépasse une certaine valeur, fonction des caractéristiques physiques du transistor MOS, on sort de la zone linéaire de la caractéristique pour entrer dans la zone de saturation dans laquelle le courant drain-source ne varie pas proportionnellement à la tension drain-source. En conséquence, un transistor MOS ne peut être utilisé pour constituer une résistance variable commandée en tension que si la tension maximum susceptible d'être appliquée aux bornes de la résistance variable, c'est-à-dire entre le drain et la source, reste inférieure à la tension correspondant au début de saturation du transistor MOS.

Or, dans un grand nombre de circuits électroniques modernes, on réalise dans un seul circuit intégré un grand nombre de fonctions différentes. En particulier, on est actuellement en mesure d'associer sur une même puce des transistors bipolaires et des transistors MOS. Dans certaines applications, les transistors bipolaires sont prévus pour supporter des tensions élevées, pas exemple de l'ordre de 50 volts, et les transistors MOS sont prévus pour supporter des tensions nettement inférieures, par exemple de l'ordre de 5 volts. On comprend que dans un tel circuit intégré on ne pourra pas utiliser un transistor MOS pour constituer une résistance variable si celle-ci est destinée à être connectée à une partie du circuit constitué de transistors bipolaires pouvant délivrer des tensions nettement supérieures.

La présente invention vise, entre autres, à surmonter cette difficulté.

La présente invention concerne donc un circuit à résistance variable commandée en tension comprenant un transistor MOS dont l'une des électrodes principales est reliée à une borne commune, une tension de commande étant appliquée entre son électrode de commande et la borne commune.

Selon l'invention, le circuit comprend :
- un diviseur résistif connecté entre une première borne et la borne commune ; et
- un circuit suiveur dont l'entrée reçoit la sortie du diviseur et dont la sortie est connectée à l'autre électrode principale du transistor MOS ;
d'où il résulte que la résistance entre la première borne et la borne commune varie en fonction de la tension de commande.

Selon un mode de réalisation de l'invention, le circuit comprend :
- un amplificateur opérationnel dont l'une des entrées est reliée à la sortie du diviseur, et dont l'autre entrée est reliée à l'autre électrode principale du transistor MOS ; et
- un transistor dont l'électrode de commande est reliée à la sortie de l'amplificateur, dont l'une des électrodes principales est reliée à la première borne et dont l'autre électrode principale est reliée à l'autre électrode principale du transistor MOS.

Selon un autre mode de réalisation, le transistor MOS est du type NMOS et le transistor est un transistor bipolaire de type NPN.

Selon un autre mode de réalisation, le transistor MOS est de type PMOS et le transistor est un transistor bipolaire de type PNP.

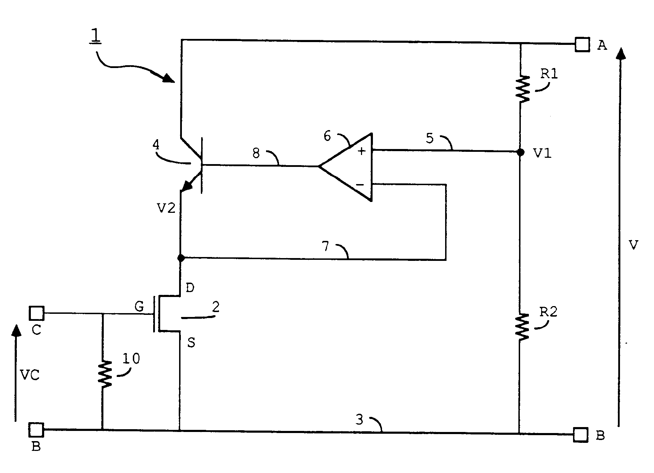

Ces objets, caractéristiques et avantages ainsi que d'autres de la présente invention seront exposés plus en détail dans la description suivante d'un mode de réalisation particulier faite en relation avec la figure jointe qui représente un mode de réalisation d'un circuit selon la présente invention.

Dans la figure, le circuit à résistance variable 1 constitue un dipôle présentant deux bornes A et B. Une tension V peut être appliquée entre les bornes A et B et la résistance R apparaissant entre les bornes A et B est une résistance variable commandée par une tension VC appliquée au circuit 1 entre une borne de commande C et la borne B.

Le circuit à résistance variable 1 comprend un transistor MOS 2 dont la source S est reliée à une ligne 3 connectée à la borne B, le drain D à l'émetteur d'un transistor bipolaire NPN 4 et la grille G à la borne de commande C. Entre les bornes A et B, est disposé un diviseur résistif composé de deux résistances R1 et R2 en série. La ligne reliant les deux résistances constitue la sortie 5 du diviseur résistif qui est à un potentiel V1. La sortie 5 du diviseur est reliée à l'entrée non-inverseuse d'un amplificateur 6 dont l'entrée inverseuse est reliée par une ligne 7 au drain D du transistor MOS. La sortie 8 de l'amplificateur opérationnel 6 est reliée à la base du transistor 4 dont le collecteur est connecté à la borne A et l'émetteur au drain D du transistor MOS. On peut disposer une résistance 10 entre les bornes C et B si le signal de commande est un courant.

Le circuit à résistance variable 1 fonctionne de la manière suivante. Si une tension V est appliquée entre les bornes A et B, une tension V1 inférieure s'établit à la sortie 5 du diviseur résistif R1 et R2. On choisit la valeur des résistances R1 et R2 de façon que, pour la valeur maximum que peut prendre la tension V, la tension V1 reste inférieure à la tension drain-source la plus élevée dans la plage de fonctionnement en mode linéaire du transistor MOS 2. Le montage de l'amplificateur 6 et du transistor 4 est celui d'un circuit suiveur, c'est-à-dire que le transistor 4 laisse passer un courant entre collecteur et émetteur de façon que la tension V2 de l'émetteur appliquée au drain D du transistor MOS, reste sensiblement égale à la tension V1. On voit donc que la tension V2 évoluera en fonction de la tension d'entrée V en restant toujours dans la plage correspondant au fonctionnement du transistor MOS 2 dans son mode linéaire. Ainsi, la tension de commande VC appliquée entre la grille du transistor MOS et la borne B commandera de façon déterminée la résistance entre drain et source du transistor MOS, puisque celui-ci restera toujours dans sa plage de fonctionnement linéaire.

Un calcul simple montre que la résistance équivalente R apparaissant entre les borne A et B, est :

$$R = R1 + R2/(1 + R2/Rm)$$

où

R1 et R2 sont les valeurs des résistances R1 et R2,

Rm est la valeur de la résistance prise par le transistor MOS entre drain et source. Celle-ci est fonction de la tension de commande VC.

On voit que le circuit à résistance variable selon l'invention peut supporter à ses bornes une tension V très nettement supérieure à celle V2 que peut supporter le transistor MOS. Par exemple, si la tension V2 que peut supporter le transistor MOS 2 entre son drain et sa source pour que celui-ci reste dans sa plage de fonctionnement linéaire, est de 5 volts, et si la tension maximum possible entre les bornes A et B est 50 volts, il suffit de choisir les valeurs de R1 et R2 de façon que (R1+R2)/R2 = 10. Bien entendu, le transistor bipolaire 4 ainsi que les composants de l'amplificateur 6 devront pouvoir supporter une telle tension V. Or, il existe de nombreuses applications, par exemple dans des circuits intégrés incluant sur une même puce des transistors bipolaires et des transistors MOS, dans lesquelles on réalise de préférence des transistors bipolaires supportant des tensions importantes et des transistors MOS supportant des tensions beaucoup plus faibles. L'invention peut alors être appliquée de façon avantageuse dans de tels circuits.

Le choix de la valeur des résistances R1 et R2 ne se fait pas uniquement en considérant le rapport (R1+R2)/R2, comme évoqué plus haut, mais en considérant également la valeur R1+R2 qui doit être nettement supérieure à la valeur R, de façon que la résistance R du circuit puisse varier dans de grandes proportions en fonction de la tension de commande VC. En fait, dans la mesure où l'amplificateur 6 a un gain élevé, on peut choisir une valeur élevée au moins pour la résistance R1.

Dans l'exemple de réalisation présenté ci-dessus, la borne A est prévue pour être au potentiel positif et la borne B au potentiel négatif. Dans ce cas, le transistor 4 est de type NPN. On peut bien évidemment envisager un circuit semblable dans lequel la borne A est à un potentiel négatif, le transistor 4 étant dans ce cas un transistor PNP. On peut aussi envisager de constituer un circuit suiveur 6, 4 comprenant uniquement des transistors de type MOS. Dans ce cas, le circuit à résistance variable selon l'invention pourra, par exemple, être utilisé dans un circuit intégré réalisé en technologie MOS.

L'invention peut être mise en application, par exemple dans un circuit de filtrage de fréquence ajustable en fréquence ou en facteur de qualité. Dans ce cas, on utilise généralement plusieurs résistances variables pour réaliser les constantes de temps du filtre. Les résistances variables doivent présenter des caractéristiques électriques très voisines ou bien corrélées. Pour cette raison, il est intéressant que toutes les résistances variables d'un circuit de filtrage soient réalisées sur un même circuit intégré, ce qui peut être facilement obtenu en utilisant des circuits à résistance variable selon la présente invention.

## Revendications

1. Circuit à résistance variable commandée en tension comprenant un transistor MOS (2) dont l'une des électrodes principales (S) est reliée à une borne commune (B), une tension de commande (VC) étant appliquée entre son électrode de commande (G) et la borne commune, caractérisé en ce qu'il comprend :
   - un diviseur résistif (R1, R2) connecté entre une première borne (A) et la borne commune (B) ; et
   - un circuit suiveur (6, 4) dont l'entrée reçoit la sortie (5) du diviseur (R1, R2) et dont la sortie (8) est connectée à l'autre électrode principale (D) du transistor MOS ;
   d'où il résulte que la résistance entre la première borne (A) et la borne commune (B) varie en fonction de la tension de commande (VC).

2. Circuit à résistance variable selon la revendication 1, caractérisé en ce que le circuit suiveur comprend :
   - un amplificateur opérationnel (6) dont l'une des entrées (+) est reliée à la sortie (5) du diviseur (R1, R2), et dont l'autre entrée (-) est reliée à l'autre électrode principale (D) du transistor MOS ; et
   - un transistor (4) dont l'électrode de commande est reliée à la sortie (8) de l'amplificateur, dont l'une des électrodes principales est reliée à la première borne (A) et dont l'autre électrode principale est reliée à l'autre électrode principale (D) du transistor MOS.

3. Circuit à résistance variable selon la revendication 2, caractérisé en ce que le transistor MOS (2) est du type NMOS et le transistor (4) est un transistor bipolaire de type NPN.

4. Circuit à résistance variable selon la revendication 2, caractérisé en ce que le transistor MOS (2) est de type PMOS et le transistor (4) est un transistor bipolaire de type PNP.

5. Circuit à résistance variable selon l'une des revendications 3 ou 4, caractérisé en ce qu'il se présente sous forme d'un circuit intégré de type associant des composants bipolaires et des composants MOS sur une même puce.

## Patentansprüche

1. Spannungsgesteuerte variable Widerstandsschaltung mit einem MOS-Transistor (2), bei dem eine der Hauptelektroden (S) mit einem gemeinsamen Anschluß (B) verbunden ist, wobei eine Steuerspannung (VC) zwischen seiner Steuerelektrode (G) und dem gemeinsamen Anschluß angelegt ist, gekennzeichnet durch
   - einen ohm'schen Spannungsteiler (R1, R2), welcher zwischen einem ersten Anschluß (A) und dem gemeinsamen Anschluß (B) angeschlossen ist, und
   - einer Folgeschaltung (6, 4), deren Eingang den Ausgang (5) des Teilers (R1, R2) aufnimmt und deren Ausgang (8) mit der anderen Hauptelektrode (D) des MOS-Transistors verbunden ist,
   wobei sich der Widerstand zwischen dem ersten Anschluß (A) und dem gemeinsamen Anschluß (B) als Funktion der Steuerspannung (VC) verändert.

2. Variable Widerstandsschaltung nach Anspruch 1, dadurch gekennzeichnet, daß die Folgeschaltung folgende Merkmale aufweist:
   - einen Operationsverstärker (6), bei dem der eine Eingang (+) mit dem Ausgang (5) des Teilers (R1, R2) verbunden ist und bei dem der andere Eingang (-) mit der anderen Hauptelektrode (D) des MOS-Transistors verbunden ist, und
   - einen Transistor (4), bei dem die Steuerelektrode mit dem Ausgang (8) des Verstärkers verbunden ist, die eine der Hauptelektroden mit dem ersten Anschluß (A) verbunden ist und die andere Hauptelektrode mit der anderen Hauptelektrode (D) des MOS-Transistors verbunden ist.

3. Variable Widerstandsschaltung nach Anspruch 2, dadurch gekennzeichnet, daß der MOS-Transistor (2) ein NMOS-Typ ist und der Transistor (4) ein bipolarer NPN-Transistor ist.

4. Variable Widerstandsschaltung nach Anspruch 2, dadurch gekennzeichnet, daß der MOS-Transistor (2) ein PMOS-Typ ist und der Transistor (4) ein bipolarer PNP-Transistor ist.

5. Variable Widerstandsschaltung nach einem der Ansprüche 3 oder 4, dadurch gekennzeichnet, daß sie in Form einer integrierten Schaltung realisiert ist, welche bipolare Komponenten und MOS-Komponenten auf demselben Chip vereinigt.

## Claims

1. A voltage-controlled variable resistance circuit comprising a MOS transistor (2), one of the main electrodes (S) of which is connected to a common terminal (B), a control voltage (VC) being applied between its control electrode (G) and the common terminal, characterized in that it comprises:
   - a voltage dividing bridge (R1, R2) switched between a first terminal (A) and said common terminal (B); and
   - a follower circuit (6, 4), the input of which receives the output (5) of the divider (R1, R2) and the output (8) is connected to the other main electrode (D) of the MOS transistor; whereby the resistance between the first terminal (A) and the common terminal (B) varies as a function of the control voltage (VC).

2. A variable resistance circuit according to claim 1, characterized in that said follower comprises:
- an operational amplifier (6), one of the inputs (+) of which is connected to the output (5) of the divider (R1, R2) and the other input (-) is connected to the other main electrode (D) of the MOS transistor; and
- a transistor (4), the control electrode of which is connected to the amplifier output (8), one of the main electrodes of which is connected to the first terminal (A) and the other main electrode is connected to the other main electrode (D) of the MOS transistor.

3. A variable resistance circuit according to claim 2, characterized in that said MOS transistor (2) is of the NMOS-type and said transistor (4) is a bipolar NPN transistor.

4. A variable resistance circuit according to claim 2, characterized in that said MOS transistor (2) is of the PMOS-type and said transistor (4) is a bipolar PNP transistor.

5. A variable resistance circuit according to any of claims 3 or 4, characterized in that said circuit is part of an integrated circuit comprising bipolar components and MOS components on one chip.